# EUROPEAN PATENT APPLICATION

(11) **EP 3 770 979 A1**
(43) Date of publication of application: **27.01.2021**
(21) Application number: 20186205.9
(22) Date of filing: 16.07.2020
(51) Int. Cl.: H01L 33/38, H01L 33/40, H01L 33/48, H01L 33/20, H01L 33/32, H01L 33/62

(54) **LIGHT EMITTING DEVICE**

(30) Priority: 22.07.2019 CN 201910661042
(71) Applicant: InnoLux Corporation, Chu-Nan, Miao-Li 350 (TW)
(72) Inventor: YAN, Tzu-Min, 350 Jhu-Nan, Miao-Li County (TW); HSIEH, Tsau-Hua, 350 Jhu-Nan, Miao-Li County (TW)
(74) Representative: 2K Patentanwälte Blasberg Kewitz & Reichel

(57) **Abstract**

A light emitting device (100A; 100B; 100C) is provided. The light emitting device (100A; 100B; 100C) includes a light emitting substrate (110). The light emitting substrate (110) has a first surface (10), a second surface (20), and a third surface (30) between the first surface (10) and the second surface (20). The light emitting device (100A; 100B; 100C) also includes a pad layer (130; 130') disposed on the light emitting substrate (110), wherein the pad layer (130; 130') includes a first portion (130a; 130a') and a second portion (130b; 130b') spaced apart from the first portion (130a; 130a'). The first portion (130a; 130a') and the second portion (130b; 130b') extend from the first surface (10) to the third surface (30), and have conductivity and light-reflectivity.

## Description

### CROSS REFERENCE TO RELATED APPLICATIONS

This application claims priority of China Patent Application No. 201910661042.2, filed on July 22, 2019, the entirety of which is incorporated by reference herein.

### BACKGROUND

### Technical Field

The disclosure relates to a light emitting device, and in particular, to a light emitting device having a pad layer.

### Description of the Related Art

As digital technology develops, light emitting devices are becoming more widely used in our daily lives. For example, light emitting devices have been widely used in modern information devices, such as televisions, notebooks, computers, mobile phones and smartphones, which have been developed to be much thinner, lighter, smaller and more fashionable. These light emitting devices may include a light emitting diode.

Light emitting diodes (LEDs) generate electromagnetic radiation (such as light) by using recombination of electron-hole pairs in p-n junctions. In a p-n junction with forward bias formed by a direct band gap material (such as GaAs or GaN), the recombination of electron-hole pairs that are injected into the depletion region generates electromagnetic radiation. The electromagnetic radiation may be at visible light region or non-visible light region, and materials with different band gaps would form LEDs with different colors.

With the current industry of light emitting devices including LEDs moving in the direction of mass production, any increase in the yield of light emitting devices may bring huge economic benefits. However, current light emitting devices are not satisfactory in every respect. Therefore, the industry still needs a light emitting device that may further improve the yield.

### BRIEF SUMMARY OF THE DISCLOSURE

A light emitting device is provided in accordance with some embodiments of the disclosure. The light emitting device includes a light emitting substrate having a first surface, a second surface, and a third surface between the first surface and the second surface. The light emitting device includes a pad layer disposed on the light emitting substrate, comprising a first portion and a second portion spaced apart from the first portion. The first portion and the second portion extend from the first surface to the third surface and are electrical conductive and light reflective.

### BRIEF DESCRIPTION OF THE DRAWINGS

The disclosure may be more fully understood by reading the subsequent detailed description and examples with references made to the accompanying drawings, wherein:
Fig. 1 is a perspective cross-sectional view of a light emitting device in accordance with some embodiments of the disclosure;
Fig. 2A is a top view of a light emitting device in accordance with some embodiments of the disclosure;
Figs. 2B-2E are side views of a light emitting device in accordance with some embodiments of the disclosure;
Fig. 3 is a perspective cross-sectional view of a light emitting device in accordance with some embodiments of the disclosure;
Fig. 4A is a top view of a light emitting device in accordance with some other embodiments of the disclosure;
Figs. 4B-4E are side views of a light emitting device in accordance with some other embodiments of the disclosure;
Fig. 5 is a perspective cross-sectional view of a light emitting device in accordance with some other embodiments of the disclosure; and
Fig. 6 is a cross-sectional view of a light emitting device in accordance with some other embodiments of the disclosure.

### DETAILED DESCRIPTION OF THE DISCLOSURE

The light emitting device provided in the disclosure is described in detail in the following description. In the following detailed description, for purposes of explanation, numerous specific details and embodiments are set forth in order to provide a thorough understanding of the disclosure. The specific elements and configurations described in the following detailed description are set forth in order to clearly describe the disclosure. It will be apparent, however, that the exemplary embodiments set forth herein are used merely for the purpose of illustration, and the inventive concept may be embodied in various forms without being limited to those exemplary embodiments. In addition, drawings of different embodiments may use like and/or corresponding numerals to denote like and/or corresponding elements in order to clearly describe the disclosure. However, the use of like and/or corresponding numerals in the drawings of different embodiments does not suggest any correlation between different embodiments. In addition, in this specification, expressions such as "first material layer disposed on or over a second material layer", may indicate the direct contact of the first material layer and the second material layer, or it may indicate one or more intermediate layers formed between the first material layer and the second material layer. In the above situation, the first material layer may not be in direct contact with the second material layer. However, expressions such as "first material layer directly disposed on or over a second material layer", indicate the situation that the first material layer and the second material layer are directly in contact.

The ranges mentioned in the disclosure all include upper and lower limits.

It should be understood that, although the terms first, second, third, etc. may be used herein to describe various elements, components, regions, layers, portions and/or sections, these elements, components, regions, layers, portions and/or sections should not be limited by these terms. These terms are only used to distinguish one element, component, region, layer, portion or section from another element, component, region, layer or section. Thus, a first element, component, region, layer, portion or section discussed below could be termed a second element, component, region, layer, portion or section without departing from the teachings of the disclosure.

Unless defined otherwise, all technical and scientific terms used herein have the same meaning as commonly understood by one of ordinary skill in the art to which this disclosure belongs. It should be appreciated that, in each case, the term, which is defined in a commonly used dictionary, should be interpreted as having a meaning that conforms to the relative skills of the disclosure and the background or the context of the disclosure, and should not be interpreted in an idealized or overly formal manner unless so defined.

It should be understood that this description of the exemplary embodiments is intended to be read in connection with the accompanying drawings, which are to be considered part of the entire written description. The drawings are not drawn to scale. In addition, structures and devices are shown schematically in order to simplify the drawing.

In the description, relative terms such as "lower," "upper," "horizontal," "vertical," "below," "above," "top" and "bottom" should be construed to refer to the orientation as then described or as shown in the drawing under discussion. These relative terms are for convenience of description and do not require that the apparatus be constructed or operated in a particular orientation. In addition, in some embodiments of the disclosure, terms concerning attachments, coupling and the like, such as "connected" and "interconnected," refer to a relationship wherein structures are secured or attached to one another either directly or indirectly through intervening structures, as well as both movable or rigid attachments or relationships, unless expressly described otherwise.

It should be noted that the term "substrate" or "panel" are meant to include devices formed on a transparent substrate and the layers overlying the transparent substrate, wherein all active elements (ex. transistors) needed may be already formed over the substrate. However, the substrate shown in the accompanying drawings is represented with a flat surface in order to simplify the drawings.

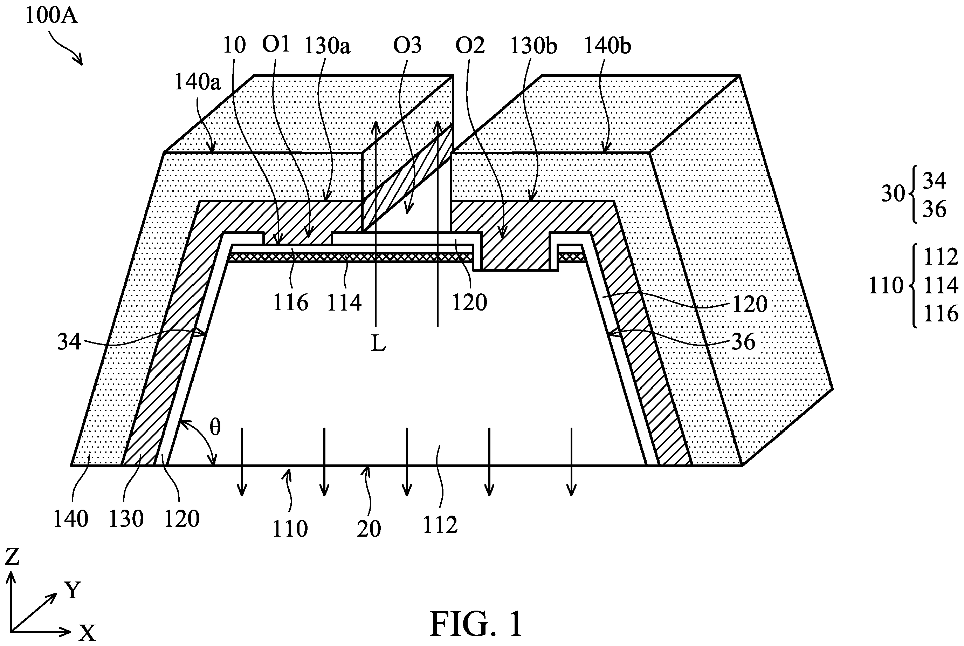

Referring to Fig. 1, Fig. 1 is a cross-sectional view of a light emitting device 100A in accordance with some embodiments of the disclosure. It is noted that the light emitting device 100A illustrated in Fig. 1 is merely an example. Besides elements illustrated in this embodiment, the light emitting device 100A may further include other elements.

As shown in Fig. 1, the light emitting device 100A includes a light emitting substrate 110. The light emitting substrate 110 includes a semiconductor layer 112, a light emitting layer 114 disposed on the semiconductor layer 112, and a semiconductor layer 116 disposed on the light emitting layer 114. The semiconductor layer 112 has a first conductivity type. The semiconductor layer 112 may be doped InₓAl_{y}Ga_{(1-x-y)}N, wherein 0 ≤ x ≤ 1, 0 ≤ y ≤ 1, and 0 ≤ (x+y) ≤ 1; for example, it may be doped GaN, InN, AlN, InₓGa₍₁₋ₓ₎N, AlₓIn₍₁₋ₓ₎N, AlₓIn_{y}Ga_{(1-x-y)}N, or the like, wherein 0 ≤ x ≤ 1, 0 ≤ y ≤ 1, and 0 ≤ (x+y) ≤ 1. The first conductivity type may be n-type, and may be formed by molecular beam epitaxy (MBE), metal organic chemical vapor deposition (MOCVD), hydride vapor phase epitaxy (HVPE), liquid phase epitaxy (LPE), or the like.

The light emitting layer 114 may include homojunction, heterojunction, single-quantum well (SQW), multiple-quantum well (MQW), or the like. In an embodiment, the light emitting layer 114 may include undoped n-type InₓGa₍₁₋ₓ₎N. In other embodiments, the light emitting layer 114 may include other common materials such as AlₓIn_{y}Ga_{(1-x-y)}N. In addition, the light emitting layer 114 may include a multiple quantum well structure with multiple well layers (such as InGaN) and barrier layers (such as GaN) alternately arranged. Moreover, methods for forming the light emitting layer 114 may include MOCVD, MBE, HVPE, LPE, or other suitable methods of chemical vapor deposition.

The semiconductor layer 116 may have a second conductivity type, and the second conductivity type is different from the first conductivity type, such as p-type. The semiconductor layer 116 may include doped InₓAl_{y}Ga_{(1-x-y)}N, wherein 0 ≤ x ≤ 1, 0 ≤ y ≤ 1, and 0 ≤ (x+y) ≤ 1, such as doped GaN, InN, AlN, InₓGa₍₁₋ₓ₎N, AlₓIn₍₁₋ₓ₎N, AlₓIn_{y}Ga_{(1-x-y )}N, or the like, wherein 0 ≤ x ≤ 1, 0 ≤ y ≤ 1, and 0 ≤ (x+y) ≤ 1. The semiconductor layer 116 may be formed by epitaxial growth processes, such as MBE, MOCVD, HVPE, LPE, or the like. In some other embodiments, the semiconductor layer 112 may be p-type, and the semiconductor layer 116 may be n-type.

In some embodiments, the light emitting substrate may include a light emitting diode. The light emitting diode may include, for example, an organic light emitting diode (OLED), a mini LED, a micro LED, or a quantum dot (QD) light emitting diode (e.g., QLED, QDLED), fluorescence, phosphor, or other suitable materials which may be arranged and combined arbitrarily, but it is not limited thereto.

As shown in Fig. 1, the light emitting substrate 110 has a first surface 10, a second surface 20, and a third surface 30 between the first surface 10 and the second surface 20. It is noted that the first surface 10, the second surface 20, and the third surface 30 may be non-flat surfaces. For example, the first surface 10 has an area exposing a portion of the upper surface of the semiconductor layer 116 and an area exposing a portion of the upper surface of the semiconductor layer 112. The second surface 20 is opposite to the first surface 10, and the second surface 20 may be composed of the lower surface of the semiconductor layer 112. In some embodiments, the third surface 30 is between the first surface 10 and the second surface 20. In some embodiments, the third surface 30 may have four surfaces: a surface 32 (not shown in Fig. 1), a surface 34, a surface 36, and a surface 38 (not shown in Fig. 1). The surfaces 32, 34, 36, and 38 can be referred to as a first sub-surface 32, a second sub-surface 34, a third sub-surface 36, and a fourth sub-surface 38 respectively. The first surface 10, the second surface 20, and the third surface 30 may be the upper surface, the lower surface, and the side surfaces of the light emitting substrate 110, respectively. The surface 32 and the surface 38 are two opposite surfaces (two surfaces which are not adjacent), and the surface 34 and the surface 36 are opposite surfaces (two surfaces which are not adjacent). The first sub-surface 32 can be connected to and connected between the second sub-surface 34 and the third sub-surface 36. The fourth sub-surface 38 can be connected to and connected between the second sub-surface 34 and the third sub-surface 36. In some embodiments, a first surface area of the first surface 10 is smaller than a second surface area of the second surface 20. The angle θ formed by the third surface 30 and the second surface 20 or the first surface 10 may be, and not limited to, between 30° and 85°.

In some embodiments, the light emitting device 100A may include a passivation layer 120. The passivation layer 120 can be disposed between the light emitting substrate 110 and the pad layer 130. In detail, the passivation layer 120 may be disposed on the light emitting substrate 110, and cover a portion of the first surface 10 and the third surface 30. More specifically, the passivation layer 120 covers a portion of the upper surface of the semiconductor layer 116, and covers the side surfaces of the semiconductor layers 112, 116 and the light emitting layer 114. In some embodiments, the material of the passivation layer 120 may include insulating materials such as, and not limited to, silicon nitride, silicon dioxide, or silicon oxynitride. The passivation layer 120 may be formed by, and not limited to, chemical vapor deposition (CVD), physical vapor deposition (PVD), atomic layer deposition (ALD), or other suitable methods.

The passivation layer 120 includes an opening O1 and an opening O2, exposing the first surface 10. More specifically, the opening O1 and an opening O2 expose the upper surfaces of the semiconductor layer 116 and the semiconductor layer 112 respectively. The opening O1 and the opening O2 may be formed in passivation layer 120 after patterning through lithography and etching processes. The lithography processes include photoresist coating (such as spin-coating), soft bake, mask alignment, exposure, post-exposure bake, photoresist development, rinsing, drying (such as hard bake), other suitable processes, or combination thereof. In addition, the lithography process may be performed or be replaced with other suitable methods, such as unmask lithography, electron-beam writing, and ion-beam writing, and it is not limited thereto. The etching processes include, and not limited to, dry etching, wet etching, or other etching methods.

In some embodiments, the light emitting device 100A includes a pad layer 130. The pad layer 130 can be disposed on the light emitting substrate 110 and can be a conductive pad layer. In detail, the pad layer 130 is disposed on the passivation layer 120, and fills into the opening O1 and the opening O2. As shown in Fig. 1, the pad layer 130 extends from the first surface 10 to the third surface 30. In some embodiments, the pad layer 130 includes a first portion 130a and a second portion 130b. The first portion 130a can be spaced apart from the second portion 130b. The first portion 130a and the second portion 130b can extend from the first surface 10 to the third surface 30 of the light emitting substrate 110. The first portion 130a may fill in the opening O1 and contact the semiconductor layer 116; the second portion 130b may fill in the opening O2 and contact the semiconductor layer 112. An opening O3 is between the first portion 130a and the second portion 130b, and exposes the passivation layer 120. In some embodiments, the light emitting substrate 110 has an n-type region and a p-type region. The first portion 130a can be electrically connected to the p-type region of the light emitting substrate 110, such as the upper surface of the semiconductor layer 116 exposed by the opening O1. The second portion 130b can be electrically connected to the n-type region of the light emitting substrate 110, such as the upper surface of the semiconductor layer 112 exposed by the opening O2, and it is not limited thereto. In some other embodiments, the first portion 130a is electrically connected to the n-type region of the light emitting substrate 110; and the second portion 130b is electrically connected to the p-type region of the light emitting substrate 110. In some embodiments, the first portion 130a and the second portion 130b are not electrically connected, and in some embodiments, the electrical potentials of the first portion 130a and the second portion 130b are different.

In some embodiments, the pad layer 130 can be electrical conductive and light reflective, and it may be multi-layered structure. For example, from the surface of the passivation layer 120, the pad layer 130 may optionally include a work function matching layer, a reflective layer, an adhesive layer, a barrier layer, and a diffusion layer. In some embodiments, the material of the pad layer 130 may include, and not limited to, Cu, Ni, Au, Ti, Cr, Pd, Pt, Ag, Al, other metallic materials, or alloys thereof. The pad layer 130 can be electrical conductive, and the light emitting substrate 110 may be electrically connected to other elements (not illustrated) through the pad layer 130. In some embodiments, the material of the reflective layer may include Ag, Al, or other suitable metals. By means of disposing the first portion 130a and/or the second portion 130b to extend to the third surface 30 of the light emitting substrate 110, the possibility that light emitted from the light emitting substrate 110 emits out of the third surface 30 may decrease; or, light L may be reflected to the second surface 20, or the light L is emitted through the opening O3. The first portion 130a and the second portion 130b can be configured to reflect light emitted from the light emitting substrate 110 to the second surface 20. Accordingly, the output efficiency of the light emitting device 100A may be enhanced. "Light reflective" described in the disclosure means that the percentage of the integral of the reflected light spectrum of a light source divided by the integral of the incident light spectrum is above 60%. In some embodiments, the light source may include, but not limited to, visible light (for example, the wavelength is between 380 nm to 780 nm) or ultraviolet light (for example, the wavelength is larger than 365 nm). That is, when the light source is visible light, the percentage of the integral of the reflected light spectrum of the light source with the wavelength in the range of 380 nm to 780 nm divided by the integral of the incident light spectrum in the same range of wavelength is above 60%.

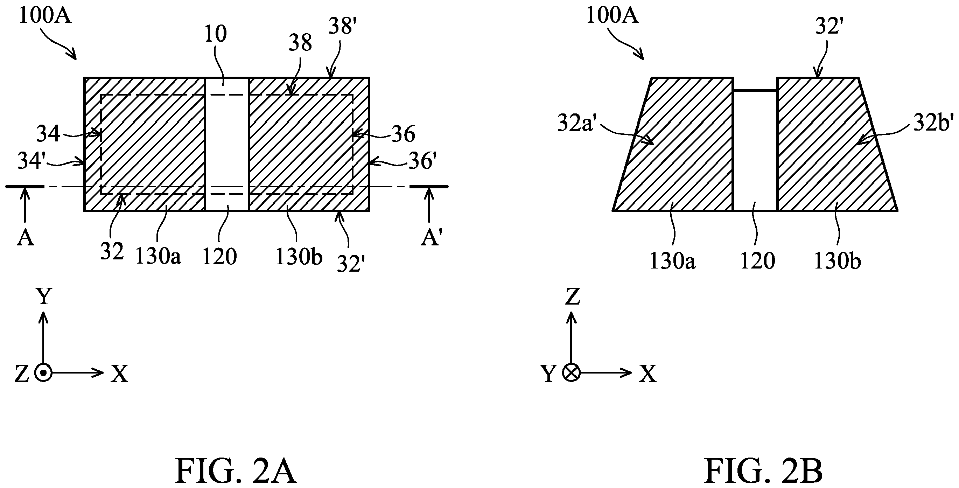

First referring to Figs. 2A-2E, Fig. 2A is a top view (observing the first surface 10 along the Z direction) of the light emitting device 100A in accordance with some embodiments of the disclosure, and Figs. 2B-2E are side views of the light emitting device 100A. To clearly illustrate the relationship among the first portion 130a, the second portion 130b, and other elements, some elements are omitted. In some embodiments, the first portion 130a covers a portion of the first surface 10; the second portion 130b covers a portion of the first surface 10, while a portion of the passivation layer 120 is not covered by the first portion 130a and the second portion 130b. In addition, the cross-sectional view taken along line A-A' in Fig. 2A may correspond to the structure shown in Fig. 1.

Refer to Figs. 2B-2C, which are schematic diagrams of the surface 32 and the surface 38 respectively. In some embodiments, the first portion 130a covers a portion of the surface 32, and the second portion 130b covers a portion of the surface 32. In some embodiments, the first portion 130a covers a portion of the surface 38, and the second portion 130b covers a portion of the surface 38. In some embodiments, the total of the first portion 130a and the second portion 130b covers 50%-90% of the surface area of the surface 32 or the surface 38. The first portion 130a and the second portion 130b are not in contact in order to prevent short circuits.

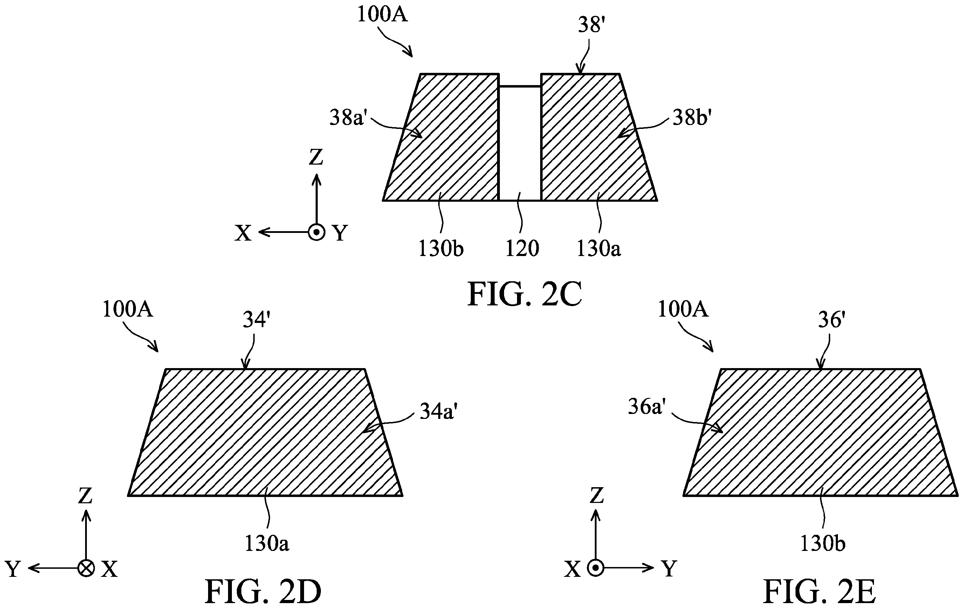

Referring to Fig. 2B again, in some embodiments, it is the schematic diagram of the outer contour surface 32'. The outer contour surface 32' includes a covering surface 32a', a covering surface 32b', and a portion of the exposed surface of the passivation layer 120. The covering surface 32a' is the outer surface of the first portion 130a and the covering surface 32b' is the outer surface of the second portion 130b. In some embodiments, the first portion 130a and the second portion 130b account for 50%-90% of the surface area of the outer contour surface 32', which means that the total area of the covering surface 32a' and the covering surface 32b' accounts for 50%-90% of the area of the outer contour surface 32'. It is noted that the term "outer contour surface" of the outer contour surfaces 32', 34', 36' and 38' in the disclosure refers to the surface enclosed by the outmost layer and all the layers, other than the outmost layer, exposed on the outmost contour when observing the light emitting device 100A in a direction. In some embodiments, the outmost layer is the pad layer 130, such as Fig. 2B, wherein the outer contour surface 32' includes the covering surface 32a', the covering surface 32b', and the exposed portion of the surface of the passivation layer 120 when observing the light emitting device 100A from the -Y to +Y direction (the direction of the Y axis arrow); in Fig. 2C, the outer contour surface 38' includes the covering surface 38a', the covering surface 38b', and the exposed portion of the surface of the passivation layer 120 when observing the light emitting device 100A from the +Y to -Y direction (the direction opposite to the Y axis arrow); in Fig. 2D, the outer contour surface 34' includes the covering surface 34a' when observing the light emitting device 100A from the -X to +X direction (the direction of the X axis arrow); in Fig. 2E, the outer contour surface 36' includes the covering surface 36a' when observing the light emitting device 100A from the +X to -X direction (the direction opposite to the X axis arrow).

Referring to Fig. 2C again, in some embodiments, it is the schematic diagram of the outer contour surface 38'. The outer contour surface 38' includes a covering surface 38a', a covering surface 38b', and a portion of the exposed surface of the passivation layer 120. The covering surface 38a' is the outer surface of the first portion 130a and the covering surface 38b' is the outer surface of the second portion 130b. In some embodiments, the first portion 130a and the second portion 130b account for 50%-90% of the surface area of the outer contour surface 38', which means that the total area of the covering surface 38a' and the covering surface 38b' accounts for 50%-90% of the area of the outer contour surface 38'.

Referring to Fig. 1 and Figs. 2D-2E, in some embodiments, the first portion 130a covers the surface 34, and the second portion 130b does not cover the surface 34. In some embodiments, the second portion 130b covers the surface 36, and the first portion 130a does not cover the surface 36. In some embodiments, the first portion 130a completely covers the surface 34, and the second portion 130b completely covers the surface 36, but other changes and adjustments are allowed and not limited thereto. In some embodiments, the first portion 130a may not completely cover the surface 34. In some embodiments, the first portion 130a covers 50%-100% of the surface area of the surface 34. In some embodiments, the second portion 130b may not completely cover the surface 36. In some embodiments, the second portion 130b covers 50%-100% of the surface area of the surface 36.

Referring to Figs. 2D-2E again, in some embodiments, they are the schematic diagrams of the outer contour surface 34' and the outer contour surface 36' respectively. In this embodiment, the first portion 130a or the second portion 130b completely covers the outer contour surface 34' or the outer contour surface 36' respectively, but it may also alternatively not completely cover the whole outer contour surface 34' or the outer contour surface 36', which is not limited thereto, and it depends on design needs. In some embodiments, the first portion 130a and the second portion 130b account for 50%-100% of the surface area of the outer contour surface 34' and 50%-100% of the surface area of the outer contour surface 36' respectively. The area of the covering surface 34a' accounts for 50%-100% of the area of the outer contour surface 34', while the area of the covering surface 36a' accounts for 50%-100% of the area of the contour surface 36'.

In some embodiments, the pad layer 130 covers 50%-90% of the total surface area of the third surface 30. In detail, the total of the first portion 130a and the second portion 130b cover 50%-90% of the total surface area of the third surface 30 (including surfaces 32, 34, 36, and 38). In some embodiments, the total of the first portion 130a and the second portion 130b cover 60%-80% of the total surface area of the third surface 30. Since the pad layer 130 extends from the first surface 10 to the third surface 30, it may cover more surface area of the third surface 30, thereby reflecting more light L to the second surface 20, thus enhancing the output efficiency of the light emitting device 100A.

In some embodiments, the total of the first portion 130a and the second portion 130b account for 50%-90% of the total surface area of all outer contour surfaces (including outer contour surfaces 32', 34', 36', and 38'). In some embodiments, the total of the first portion 130a and the second portion 130b account for 60%-80% of the total surface area of all outer contour surfaces, which means that the total area of the covering surfaces 32a', 32b', 34a', 36a', 38a', and 38b' accounts for 60%-80% of total area of the outer contour surfaces 32', 34', 36', and 38'.

In some embodiments, the light emitting device 100A includes a connection layer 140, as shown in Fig. 1. The connection layer 140 can be disposed on the pad layer 130. The connection layer 140 can extend from the first surface 10 to the third surface 30. In some embodiments, the material of the connection layer may include Sn, Sn alloys, In, In alloys, Cu, Cu alloys, Au, Au alloys, other materials or alloys, but they are not limited thereto. In some embodiments, the connection layer 140 may include a multi-layered structure, formed of different metallic or alloy materials. In addition, the connection layer 140 may also include materials with high reflectivity, such as Ag, Ag alloys, Al, Al alloys, and other suitable materials, but they are not limited thereto. In some embodiments, the connection layer 140 may be used in soldering. The connection layer 140 can be a solder layer.

In some embodiments, please refer to the cross-sectional view of Fig. 1 again, the connection layer 140 may include a first block 140a and a second block 140b, correspondingly disposed on the first portion 130a and the second portion 130b respectively. In some embodiments, the contour of the connection layer 140 may be the same as or similar to that of the pad layer 130. In some embodiments, the first block 140a covers a portion of the first surface 10; the second block 140b also covers a portion of the first surface 10. The structure of the first block 140a and/or the second block 140b of the connection layer 140 covering above the pad layer 130 may be similar to that of the first portion 130a and the second portion 130b of the pad layer 130 illustrated in Figs. 2A-2E.

In some embodiments, the first block 140a covers a portion of the surface 32, and the second block 140b covers a portion of the surface 32. In some embodiments, the first block 140a covers a portion of the surface 38, and the second block 140b covers a portion of the surface 38. In some embodiments, the total of the first block 140a and the second block 140b covers 50%-90% of the surface area of the surface 32 or the surface 38. In some embodiments, the first block 140a and the second block 140b account for 50%-90% of the surface area of the outer contour surface 32' or the outer contour surface 38'.

In some embodiments, the first portion 130a covers 50%-100% of the surface area of the surface 34, and the second portion 130b covers 50%-100% of the surface area of the surface 36. In some embodiments, the total of the first portion 130a and the second portion 130b covers 50%-90% of the total surface area of the third surface 30 (including the surfaces 32, 34, 36, and 38). In some embodiments, the total of the first portion 130a and the second portion 130b covers 60%-80% of the total surface area of the third surface 30. Since the solder layer 140 extends from the first surface 10 to the third surface 30 and covers more surface area of the third surface 30, it may reflect more light L to the second surface 20, thereby enhancing the output efficiency of the light emitting device 100A.

In some embodiments, the first block 140a and the second block 140b account for 50%-100% of the surface area of the outer contour surface 34' or the contour surface 36' respectively. In some embodiments, the total of the first block 140a and the second block 140b accounts for 50%-90% of the total surface area of the outer contour surfaces 32', 34', 36', and 38'. In some embodiments, the total of the first block 140a and the second block 140b accounts for 60%-80% of the total surface area of the outer contour surfaces 32', 34', 36', and 38'. In some embodiments, the pad layer 130 and the connection layer 140 may be patterned through the same etching process to form the first portion 130a, the second portion 130b, the first block 140a, and the second block 140b with similar shapes and /or contours. In some embodiments, after depositing the metallic materials of the pad layer 130 and the connection layer 140, lithography and etching processes may be performed to pattern the pad layer 130 and the connection layer 140. In addition, in this embodiment, metal oxides are not used as the reflecting layer, but metallic materials are directly used as the reflecting layer. If metal oxides are used as the reflecting layer, the thickness of the light emitting device would become thicker. Besides, this embodiment integrates the processes for forming the reflecting layer and the processes for forming the pad layer 130, such that the contour/shape of the reflecting layer of the pad layer 130 is the same as or similar to the connection layer 140. Accordingly, the steps for forming the light emitting device 100A may be simplified.

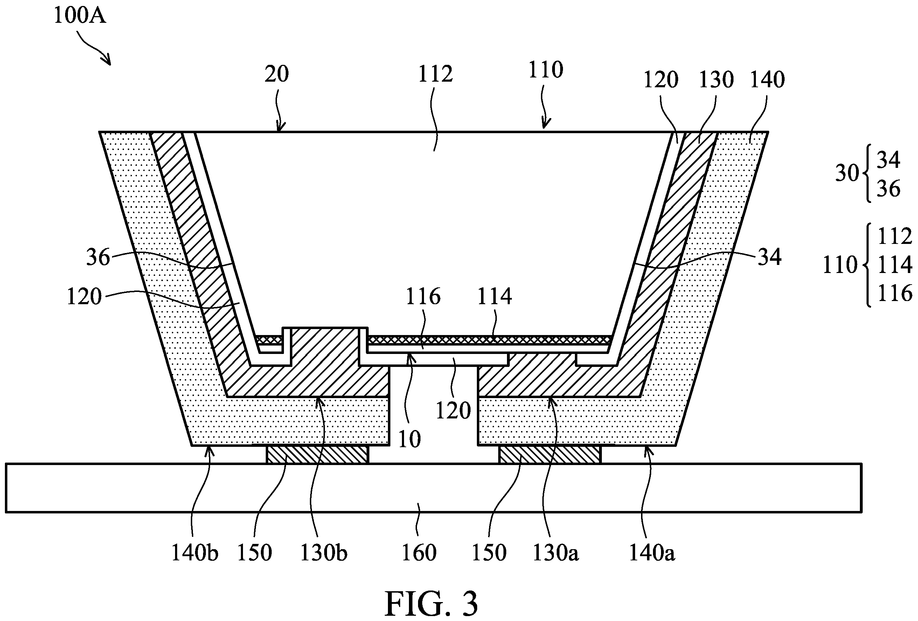

Referring to Fig. 3, Fig. 3 is the cross-sectional view of the light emitting device 100A in accordance with some embodiments of the disclosure. The light emitting device 100A may include a driving substrate 160, and the driving substrate 160 further includes a conductive pad 150. The light emitting substrate 110 is fixed on the driving substrate 160 through the conductive pad 150. In some embodiments, the connection layer 140 of the light emitting device 100A is electrically connected to the conductive pad 150 through a soldering method. In this case, the first surface 10 of the light emitting substrate 110 faces the driving substrate 160; i.e. compared with the second surface 20, the first surface 10 is closer to the driving substrate 160.

The material of the conductive pad 150 may include a conductive material, and not limited to, such as Cu, Ni, Au, Ti, Al, Cr, Pt, Ag, other metallic materials, or alloys thereof.

In accordance with applications of the light emitting device 100A, the driving substrate 160 may be a substrate that includes various active and/or passive elements. The driving substrate 160 may include flexible or non-flexible substrates such as, but not limited to, glass substrates, sapphire substrates, ceramics substrates, plastic substrates, or other suitable substrates, wherein the material of the plastic substrates may be polyimine (PI), polyethylene terephthalate (PET), polycarbonate (PC), polyether oxime (PES), polybutylene terephthalate (PBT), polynaphthalene ethylene glycolate (PEN) or polyarylate (PAR), other suitable materials, or combinations thereof.

The driving substrate 160 may include various active elements, such as thin film transistors. The thin film transistors may include switch transistors, driving transistors, reset transistors, or other thin film transistors. In addition, the driving substrate 160 may include a display medium layer, such as a liquid crystal display (LCD) layer; then, the light emitting substrate 110 may be used as a backlight. In some embodiments, the driving substrate 160 may also include chips. The driving substrate 160 includes passive elements such as, and not limited to, capacitors, inductors, or other passive elements. In some embodiments, the conductive pad 150 may be electrically connected to active and/or passive elements or connect to other circuits, and then connected to the driving substrate 160, but not limited thereto.

In some embodiments, the light emitting device 100A may be used as modern information equipment such as televisions, notebooks, computers, mobile phones, smartphones, public information displays, touch displays, or tiled displays, etc. By making the pad layer 130 have the first portion 130a and the second portion 130b extending from the surface 10 to the third surface 30, and have electrical conductive and light reflective properties, the output efficiency of the light emitting device 100A may be better, and the light emitting device 100A becomes more suitable to be used as the above information equipment. In some embodiments, at least one of the pad layer 130 and the connection layer 140 has electrical conductive and light reflective properties, which also makes the output efficiency of the light emitting device 100A better.

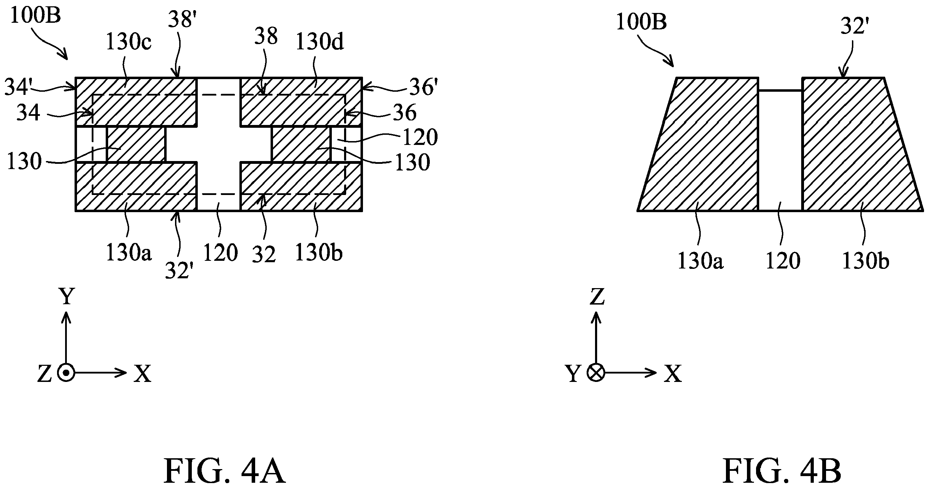

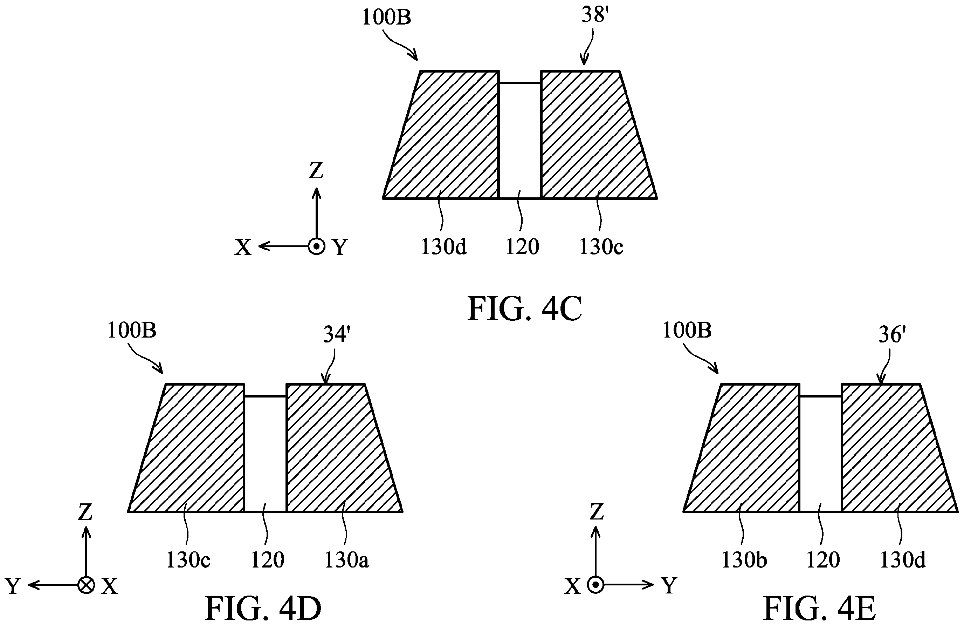

The layout of the pad layer 130 may not be limited to what is shown in Figs. 2A-2E. Referring to Figs. 4A-4E, Fig. 4A is a top view (observing the first surface 10 along the Z direction) of a light emitting device 100B in accordance with some other embodiments of the disclosure. Figs. 4B-4E are side views of the light emitting device 100B. To clearly illustrate the relationship among the pad layer and other elements, some elements are omitted. In some embodiments, the pad layer 130 includes a third portion 130c and a fourth portion 130d. As shown in Fig. 4A, the first portion 130a, the second portion 130b, the third portion 130c, and the fourth portion 130d each covers a portion of the first surface 10 respectively. In addition, the first portion 130a connects to the third portion 130c; the second portion 130b connects to the fourth portion 130d.

Please refer to Fig.4A, in some embodiments, the first portion 130a covers a portion of the surface 32 and the surface 34; the second portion 130b covers a portion of the surface 32 and the surface 36; the third portion 130c covers a portion of the surface 34 and the surface 38; the fourth portion 130d covers a portion of the surface 36 and the surface 38. In some embodiments, the first portion 130a and the second portion 130b cover 50%-90% of the surface area of the surface 32; the first portion 130a and the third portion 130c cover 50%-90% of the surface area of the surface 34; the third portion 130c and the fourth portion 130d cover 50%-90% of the surface area of the surface 38; the second portion 130b and the fourth portion 130d cover 50%-90% of the surface area of the surface 36.

Referring to Figs. 4B-4E again, in some embodiments, they are the schematic diagrams of the outer contour surfaces 32', 34', 36', and 38' respectively. In some embodiments, the total of the first portion 130a and the second portion 130b accounts for 50%-90% of the surface area of the outer contour surface 32'; the total of the first portion 130a and the third portion 130c accounts for 50%-90% of the surface area of the outer contour surface 34'; the total of the third portion 130c and the fourth portion 130d accounts for 50%-90% of the surface area of the outer contour surface 38'; the total of the second portion 130b and the fourth portion 130d accounts for 50%-90% of the surface area of the outer contour surface 36'.

Various changes and adjustments may be made in the embodiments of the disclosure. In some embodiments, the shapes and contours of the portions of the pad layer 130 may include any shapes, and the disclosure is not limited to this; the shapes and contours of the portions of the connection layer 140 may include any shapes, and the disclosure is not limited to this.

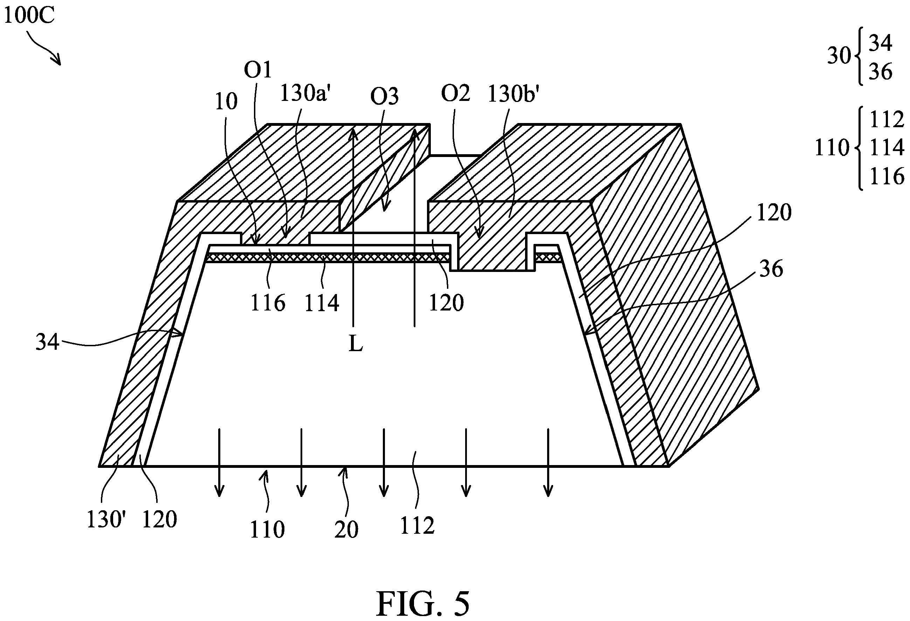

Referring to Fig. 5, Fig. 5 is a cross-sectional view of a light emitting device 100C in accordance with some embodiments of the disclosure. It is noted that the light emitting device 100C illustrated in Fig. 5 is merely an example, and the light emitting device 100C may further include other elements besides the elements illustrated in this embodiment. In some embodiments, the light emitting device 100C includes a pad layer 130'. In this embodiment, patterning processes may be performed after the deposition of the metallic material of the pad layer 130' in order to form a first portion 130a' and a second portion 130b'. In this embodiment, the connection layer may be omitted. The materials and/or contours of the first portion 130a' and the second portion 130b' may be the same as or similar to the materials and/or contours of the first portion 130a and the second portion 130b illustrated in Fig. 1.

In some embodiments, as shown in Fig. 5, the first portion 130a' covers a portion of the surface 32 (not shown), and the second portion 130b' covers a portion of the surface 32. In some embodiments, the first portion 130a' covers a portion of the surface 38 (not shown), and the second portion 130b' covers a portion of the surface 38. In some embodiments, the total of the first portion 130a' and the second portion 130b' covers 50%-90% of the surface area of the surface 32 or the surface 38. The first portion 130a' and the second portion 130b' are not in contact in order to prevent short circuits. In some embodiments, the total of the first portion 130a' and the second portion 130b' covers 50%-90% of the total surface area of the third surface 30 (including surfaces 32, 34, 36, and 38). In some embodiments, the total of the first portion 130a' and the second portion 130b' covers 60%-80% of the total surface area of the third surface 30. In some embodiments, the total of the first portion 130a' and the second portion 130b' accounts for 50%-90% of the surface area of the outer contour surface 32' or the outer contour surface 38'. In some embodiments, the total of the first portion 130a' and the second portion 130b' accounts for 50%-90% of the total surface area of all outer contour surfaces (including the outer contour surfaces 32', 34', 36', and 38', which are not shown in Fig. 5). In some embodiments, the total of the first portion 130a' and the second portion 130b' accounts for 60%-80% of the total surface area of all outer contour surfaces. For details of the outer contour surfaces mentioned above, please refer to Figs. 2A-2E and related paragraphs.

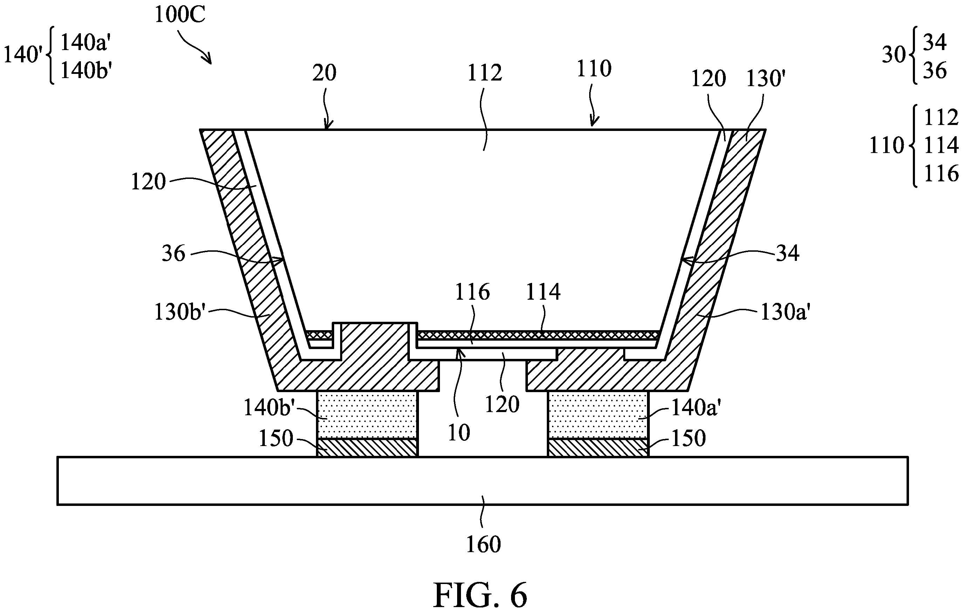

Referring to Fig. 6, Fig. 6 is a cross-sectional view of the light emitting device 100C in accordance with some embodiments of Fig. 5. In some embodiments, the light emitting device 100C includes the driving substrate 160, and the driving substrate 160 further includes a connection layer 140' and the conductive pad 150. The stacking order from the driving substrate 160 to the pad layer 130' may be the driving substrate 160, the conductive pad 150, the connection layer 140', and the pad layer 130' sequentially, but the order may be adjusted in accordance with the needs.

In this embodiment, the metallic material of the connection layer 140' and the conductive pad 150 may be deposited on the driving substrate 160 first, and then patterning processes are performed to form the conductive pad 150, the first block 140a', and the second block 140b' with similar shapes and/or contours. In the following, the first block 140a' and the second block 140b' are bonded to the first portion 130a' and the second portion 130b' respectively. In this embodiment, the pad layer 130', and the connection layer 140' are not patterned through the same etching process.

In this embodiment, since the pad layer 130' extends from the first surface 10 to the third surface 30, it covers more surface area of the third surface 30, and therefore it may reflect more light, which is emitted from the light emitting substrate 110, to the second surface 20, and thereby enhance the output efficiency of the light emitting device 100C.

According to some embodiments, the pad layer is light reflective and extends to the side surface of the light emitting substrate, light can be reflected efficiently and light output efficiency can be improved.

Although some embodiments of the disclosure and their advantages have been described above, it should be understood that various changes, substitutions and alterations can be made herein without departing from the spirit and scope of the disclosure as defined by the appended claims. For example, it will be readily understood by one of ordinary skill in the art that many of the features, functions, processes, and materials described herein may be varied while remaining within the scope of the disclosure. Moreover, the scope of the present application is not intended to be limited to the particular embodiments of the process, machine, manufacture, composition of matter, means, methods and steps described in the specification. As a person having ordinary skill in the art will readily appreciate from the disclosure, processes, machines, manufacture, compositions of matter, means, methods, or steps, presently existing or later to be developed, that perform substantially the same function or achieve substantially the same result as the corresponding embodiments described herein may be utilized according to the disclosure. Accordingly, the appended claims are intended to include within their scope such processes, machines, manufacture, compositions of matter, means, methods, or steps. In addition, each claim forms a respective embodiment, and the scope of the disclosure also encompasses every claim and the combination thereof. The features among various embodiments may be mixed and used as long as they do not violate the spirit of the invention or conflict with each other.

## Claims

1. A light emitting device, comprising:
a light emitting substrate having a first surface, a second surface, and a third surface between the first surface and the second surface; and
a pad layer disposed on the light emitting substrate, comprising a first portion and a second portion spaced apart from the first portion,
wherein the first portion and the second portion extend from the first surface to the third surface and are electrical conductive and light reflective.

2. The light emitting device of claim 1, wherein the first portion and the second portion are configured to reflect light emitted from the light emitting substrate to the second surface.

3. The light emitting device of claim 1 or 2, wherein a first surface area of the first surface is smaller than a second surface area of the second surface.

4. The light emitting device of any of claims 1 to 3, wherein the light emitting substrate has an n-type region and a p-type region, and wherein the first portion is electrically connected to the n-type region, and the second portion is electrically connected to the p-type region.

5. The light emitting device of any of claims 1 to 4, wherein the pad layer covers 50-90% of a total surface area of the third surface.

6. The light emitting device of any of claims 1 to 5, further comprising:
a connection layer disposed on the pad layer, wherein the connection layer extends from the first surface to the third surface.

7. The light emitting device of claim 6, wherein the connection layer has a first block disposed on the first portion of the pad layer and a second block disposed on the second portion of the pad layer.

8. The light emitting device of any of claims 1 to 7, wherein the pad layer accounts for 50-90% of a total surface area of all outer contour surfaces.

9. The light emitting device of any of claims 1 to 8, further comprising:
a passivation layer disposed between the light emitting substrate and the pad layer.

10. The light emitting device of any of claims 1 to 9, further comprising:
a driving substrate, wherein the light emitting substrate is fixed on the driving substrate, and the first surface of the light emitting substrate faces the driving substrate.
